# EUROPEAN PATENT APPLICATION

(11) **EP 1 550 704 A1**
(43) Date of publication of application: **06.07.2005**
(21) Application number: 04257951.6
(22) Date of filing: 18.12.2004
(51) Int. Cl.: C09J 175/00, C09J 9/02, H05K 9/00, C09J 113/00, C09J 123/00, C08G 65/336

(54) **Improved adhesive**

(30) Priority: 24.12.2003 US 532769 P
(71) Applicant: Rohm and Haas Electronic Materials, L.L.C., Marlborough, Massachusetts 01752 (US)
(72) Inventor: Levey, Peter R., Bellmore New York 11710 (US); Jasne, Stanley J., Sunnyvale California 94086 (US); Brown, Neil D., Merrick New York 11566 (US); Brese, Nathaniel E., Lansdale Pennsylvania 19446 (US)
(74) Representative: Buckley, Guy Julian

(57) **Abstract**

A composition is provided which includes at least one silyl-terminated polymer, at least one polymer with anhydride functionalities, acid functionalities or combinations thereof, and one or more catalysts.

## Description

### Background of the Invention

The present invention is directed to an improved adhesive. More specifically, the present invention is directed to an improved adhesive having a blend of a silyl-terminated polymer and a polymer with anhydride or acid functionalities or combinations thereof.

Many compositions and methods are known in the scientific and technical literature describing means for achieving improvements in adhesion between adhesives and various substrates. Although there have been numerous improvements in adhesive technology, there is still a considerable need for improved bonding compositions and methods. An example of one improvement in adhesive technology was the modification of natural rubber and certain synthetic elastomers by the incorporation of carboxylic acid functionality into the rubber chain through copolymerization or grafting techniques with such monomers as acrylic and methacrylic acid or esters of these acids, which may later be converted to carboxylic acid functionalities by saponification of the esters. These techniques have resulted in useful elastomers with significant bonding capabilities, but these methods have not received general acceptance for the reason that the elastomers formed by such techniques are usually viscous and hard to handle, the polymerization chemistry is complicated and difficult, and the products are not compatible with a wide range of other elastomers. To a limited extent, maleic acid, fumaric acid, itaconic acid and the anhydride derivatives of maleic acid and itaconic acid have been used to graft or adduct solid elastomers with carboxylic acid functionality. Again these methods suffer from mechanical difficulties associated with handling the high molecular weight solid elastomer during the chemical reactions.

Another method to boost adhesion of an elastomer is the addition of lower molecular weight carboxylic acids or derivatives to the rubber compound during mixing. While in some applications this has been achieved, this method is not generally accepted because most carboxylic acids and derivatives do not behave well in the mixing step due to high melting points or low solubility in rubber compounds. These materials are not usually compatible with the finished unvulcanized elastomer, and also tend to interfere with the vulcanization step.

In part, the difficulty with adhesion of elastomers to a variety of substrates lies in the generally non-polar nature of most natural and synthetic elastomers which do not contain bonding species which react or coordinate with the polar bonds at the interface with a mineral, fiber, or metal surface. In addition, those surfaces that do not contain polar bonding surfaces are inert to many kinds of reactions, which may provide adhesive interface with non-polar bonds. There are also physical problems in the adhesive interface for this type of bond rarely contains bonding elements having the same coefficient of expansion, or the same elastic modulus.

Examples of methods to provide satisfactory bonds include: a. Chemical methods to modify the elastomer interface by chemically altering the surface of the elastomer with polar bonds such as by chlorination of the elastomer surface with sodium hypochlorite solutions or other forms of chlorine containing treatments, or treatment of the surface of polytetrafluoroethylene with sodium napthalide; b. Chemical methods to modify the substrate interface by chemically altering the surface of the substrate with non-polar bonds such as by treating a metal surface with primer systems designed to impart a bonding surface which is more compatible with non-polar elastomers; c. Physically modifying the substrate interface with a coating which bonds to both elastomeric and substrate surfaces with greater bonding energy than either alone may be made to bond such as sputter coated brass on steel wire bonded with sulfur-cured rubber; d. Milling processes where chemical bonds have been broken between rubber fragments by mechanical shear forces which have reformed in the presence of maleic anhydride to give malenized rubber; e. Maleinizing low molecular weight polybutadienes and other highly unsaturated polymers used as chemical intermediaries for the production of air dried coatings and electrodepositional primer coatings; f, and mechanically or chemically roughening the surface to increase the surface area available to form an elastomeric bond, such as with an abrasive or an oxidizing chemical treatment, such as with MnO₄³⁻; g. Combinations of several of these methods may be used together. These various bonding techniques generally have either failed to provide truly satisfactory bonding results, or have provided limited results.

In addition to the elastomers described above, elastomers having adhesive properties may be conductive. U.S. 6,331,349 discloses conductive elastomers. The elastomers contain a primary polymer having end groups that are capable of chemically reacting with each other in the presence of moisture to form a derivative polymer having longer chain lengths than the primary polymer. Such polymers include isocyanate capped polyester prepolymers. The elastomer also includes a noncross-linked elastomer that is not chemically reactive with itself or with the first polymer in the presence of moisture. Such polymers include styrene-butadiene-styrene block copolymers. Fillers, which are electrically conductive, are included in the elastomer composition. Such fillers include noble metal based fillers and non-noble metal based fillers. The conductive elastomers are employed as EMI shielding gaskets.

EMI shielding gaskets are used on electronic equipment to provide protection against interference from electromagnetic energy, including radio frequency interference (RFI) and more broadly all bands of interference commonly called electromagnetic interference (EMI). The shielding has an electrically conductive element, which prevents external EMI from interfering with an electronic device or protects other adjacent electronic devices form EMI emitted by an electronic device.

Typically, EMI gaskets are prepared in one of three configurations: linear, die cut or compression molded. Linear gaskets are extrusions or moldings of a defined, straight length. Die cut gaskets are sheets of material cut by a die to a desired shape, such as round, or square. Compression molded are gaskets with a configuration formed by placing uncured elastomer into a specifically designed mold which is then subjected to compression and then cured to cause the elastomer to assume the desired gasket configuration.

All three methods have disadvantages especially when used to form complex multidirectional or multiaxial gaskets, such as may occur in devices with a number of compartments that each need to be shielded from each other as well as the external environment. Moreover, the problems are more critical on smaller devices, such as cellular phones, notebook computers and other hand held devices, where the diameter of the gasket becomes very small and the ability to manufacture and attach such gaskets securely becomes very difficult and labor intensive.

Using linear gasketing material to form complex multiaxis/multidirectional gaskets is difficult, time consuming and costly. Each gasket portion must be hand cut and bonded to the adjacent portions of other linear gaskets and then bonded or secured in position upon a substrate.

Die cutting of conductive sheet stock works in many instances especially in two plane applications, provided that each portion of the gasket is wide enough and thick enough to be self-supportive. Die cutting parts however result in significant waste of the sheet stock because the material is a cross-linked resin such as silicone or polyurethane. This is not acceptable as it drives up the cost of such parts unacceptably. Further as diecutting is a rough process, the sheet stock needs to be fairly stiff and self-supportive which is opposite of that which is desired by gasket users.

Compression molding is slow and again generates scrap in the form of flash, which must be removed. Further, each gasket design must use a specifically designed mold, making the process expensive for all but large volume stock items.

The '349 patent alleges that the conductive elastomer is suitable for use as a form-in-place gasket. Such elastomers are in the form of a paste, caulk, gel or viscous fluid prior to curing. They are applied using a suitable dispenser, and are placed along a desired gasket configuration to create the form-in-place gasket. Such gaskets are useful when positioned between two adjacent substrates such as a box cover to form an electrical bridge or continuity between the two conductive substrates thereby eliminating or reducing the potential for stray EMI.

In addition to having electrical conductivity and flexibility for a form-in-place gasket, such elastomers also need sufficient adhesion to the substrates to which they are applied. Insufficient adhesion between the substrates may result in gaps or crack forming between the substrates, thus resulting in defective EMI shielding.

Although there are numerous adhesives and methods of employing the adhesives such as for gaskets, there is still a need for improved adhesives.

### Summary of the Invention

A composition is provided which includes at least one silyl-terminated polymer, at least one polymer with anhydride or acid functionalities or combinations thereof, and one or more catalysts. The composition may be used as an adhesive for joining substrates together.

In another embodiment a composition is provided which includes at least one silyl-terminated polymer, at least one polymer with anhydride or acid functionalities or combinations thereof, one or more catalysts, and one or more conductive fillers. The composition may be used as an EMI or RFI shield such as a form-in-place (FIP) gasket. Such compositions may be used in a system for forming gaskets using a table and dispenser that are capable of moving in multiaxial directions relative to each other and the substrate to be gasketed.

The compositions are sufficiently viscous and form stable such that they do not significantly slump, sag or run between the time of application and the time of curing. The compositions may be in the form of a paste, caulk, gel or viscous fluid.

In another embodiment an EMI shielded substrate is provided which includes a first electrically conductive substrate; a second electrically conductive substrate adjacent to the first substrate; and a form-in-place gasket formed on and bonded to a predetermined portion of the first substrate to provide electrical connection and EMI shielding between the first and second substrates, the form-in-place gasket includes a composition formed of at least one silyl-terminated polymer, at least one polymer with anhydride or acid functionalities or combinations thereof, one or more catalysts, and one or more electrically conductive fillers.

The form-in-place gaskets eliminate forming the gasket and then applying it in a separate step as with die cut or compression molded gaskets. Applications of the form-in-place gasket are less labor intensive than linear and die cut gaskets because there is no hand assembly of complex gasket shapes or mounting of the gaskets into place. Further, there is no need for the manufacture of specialized dies or molds, which are useful for only one gasket configuration. In contrast, the form-in-place gaskets may be readily applied to any substrate in any configuration and in a cost effective manner with a minimal investment for tooling. Additionally, with the use of pre-programmable application equipment, one may store an infinite number of gasket configurations, which may be called up and used quickly and repeatedly without the necessity to manufacture a specific die or mold.

Also the compositions, which form the form-in-place gaskets allow for exact placement of very small diameter gaskets (e.g. 0.025 cm diameter or less). Such small diameter gaskets are difficult to achieve.

The compositions with conductive fillers also may be used, for example, as antistatic coatings for tools, floors, table-tops, door knobs and plastic coatings. Other applications are envisioned as is discernable from the detailed description of the invention.

### Detailed Description of the Invention

As used throughout the specification, the following abbreviations have the following meaning, unless the context clearly indicates otherwise: °C = degrees Centigrade; gm = gram; mg = milligram; L = liter; mL= milliliter; psi = pounds/square inch; m = meter; dm = decimeter; mm = millimeter; µm = micron = micrometer; cm = centimeter; nm nanometer; mΩ = milliohms; cps = centipoises; dB = decibels; N = Newtons; MHz = megahertz; GHz = gigahertz; ASTM = American standard testing method; EMI = electromagnetic interference; RFI = radio frequency interference.

The terms "polymer" and "copolymer" are used interchangeably throughout the specification. All weights are wt% unless otherwise designated.

All numerical ranges are inclusive and combinable in any order, except where it is logical that such numerical ranges are constrained to add up to 100%.

Compositions are provided which include at least one silyl-terminated polymer, at least one polymer with anhydride functionalities and one or more catalysts. The compositions may be used as an adhesive for joining substrates together. The compositions may be employed as adhesives on any suitable substrate. Examples of such substrates include elastomers, plastics, metals, ceramics, composites, fabrics and fibers. Additionally, the compositions are suitable for use as sealing agents such as in hermetic seals and gaskets.

Any suitable silyl-terminated polymer may be employed. Examples of silyl-terminated polymers that may be used include silylated polyurethane, silylated polyethers, and silylated polyesters. The silyl-terminated polymers include two or more reactive silyl groups.

An example of a suitable silyl-terminated polymer that may be used is an oxyalkylene polymer having at least one reactive silyl group at each end of the polymer molecule. The backbone of the silyl-terminated oxyalkylene polymer has repeating units represented by the formula: ―R―O― wherein R represents a divalent organic group such as straight or branched alkylene groups containing 1 to 14 carbon atoms, or such as straight or branched alkylene groups containing 2 to 4 carbon atoms. Examples include polypropylene oxide backbones, polyethylene oxide backbones, and copolyethylene oxide/polypropylene oxide backbones. Other repeating units may include, but are not limited to ―CH₂O―, ―CH₂CH(CH₃)O―, ―CH₂CH(C₂H₅)O―, ―CH₂C(CH₃)₂O―, and ―CH₂CH₂CH₂CH₂O―.

The reactive silyl group contained in the silyl-terminated polymers may be represented by formula I:

-[Si(R²)₂₋ₐ(X)ₐO]ₚ―Si(R³)_{3-b}(X)_{b}

wherein R² and R³ are the same or different and each represents an alkyl group containing 1 to 20 carbon atoms, an aryl group containing 6 to 20 carbon atoms, an aralkyl group containing 7 to 20 carbon atoms or a triorganosiloxy group of the formula (R⁴)₃SiO― wherein R⁴ independently represents a hydrocarbon group containing 1 to 20 carbon atoms and, when two or more R² and R³ groups are present, they may be the same or different; X represents a hydrolyzable group or a hydroxyl group and, when two or more X groups are present, they may be the same or different; a represents an integer of 0 to 2; b represents an integer of 0 to 3; and p represents an integer of 0 to 19 and, when p is 2 or more, the -[Si(R₂)₂₋ₐ(X)ₐO] groups may be the same or different. In the reactive silyl group represented by the above general formula, there is at least one hydrolyzable group or hydroxyl group represented by X.

The above-mentioned alkyl group containing 1 to 20 carbon atoms includes, but is not limited to methyl, ethyl, isopropyl, butyl, t-butyl, and cyclohexyl.

The above-mentioned aryl group containing 6 to 20 carbon atoms includes, but is not limited to, phenyl, naphthyl.

The above-mentioned aralkyl group containing 7 to 20 carbon atoms includes, but is not limited to, benzyl.

The above-mentioned monovalent hydrocarbon group containing 1 to 20 carbon atoms includes, but is not limited to, methyl, ethyl, isopropyl, butyl, t-butyl, pentyl, ethynyl, 1-propenyl, vinyl, allyl, 1-methylbutyl, 2-ethylbutyl; and phenyl.

The above-mentioned hydrolyzable group represented by X is not limited to any particular species and includes a hydrogen atom, halogen atoms, and alkoxyl, acyloxy, ketoximate, amino, amido, acid amido, aminoxy, mercapto, and alkenyloxy groups.

One to three hydroxyl groups and hydrolyzable groups each represented by X may be bound to one silicon atom. The sum total of the hydroxyl and/or hydrolyzable groups in the reactive silyl group represented by the above general formula is preferably within the range of 1 to 5.

The number of silicon atoms forming the above-mentioned reactive silyl group may be 1 or 2 or more.

Methods of introducing a reactive silyl group onto a polymer, such as a polyether, or a polyoxyalkylene polymer, are well known in the art. For example, polymers having terminal hydroxyl, epoxy or isocyanate functional groups can be reacted with a compound having a reactive silyl group and a functional group capable of reacting with the hydroxyl, epoxy or isocyanate group.

As another example, silyl-terminated polyurethane polymers may be used. A suitable silyl-terminated polyurethane polymer may be prepared by reacting a hydroxyl-terminated polyether, such as a hydroxyl-terminated polyoxyalkylene, with a polyisocyanate compound, such as 4,4'-methylenebis-(phenylisocyanate), to form an isocyanate-terminated polymer, which can then be reacted with an aminosilane, such as aminopropyltrimethoxysilane, to form a silyl-terminated polyurethane.

Silyl-terminated polyesters are those compounds having the reactive silyl groups discussed above with a backbone comprising ―O―CO―R⁵―CO―O―R⁶― or ―R⁷―CO―O― repeat units, wherein R⁵, R⁶ and R⁷ are divalent organic groups such as straight or branched alkylene groups.

Suitable silyl-terminated polyethers include, but are not limited to silyl-terminated polyethers having formula II: 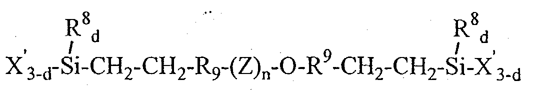 wherin R⁸ is a monovalent hydrocarbon group having from 1 to 3 carbons such as a methyl, ethyl or propyl; X' is an alkoxy group such as a methoxy, ethoxy and propoxy group; R⁹ is a divalent group such as ―CH₂―, 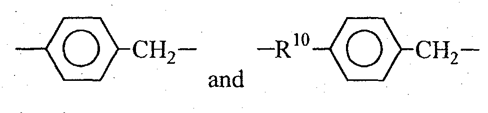 where R¹⁰ is a hydrocarbon group having from 1 to 3 carbon atoms; d is an integer such as 0, 1, and 2; Z is -O-CH₂-, 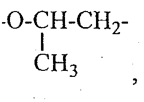 ―O―C(CH₃)₂―CH₂―, and ―O―CH₂―CH₂―CH₂―CH₂―; and n is an integer such that the molecular weight of the polyether of formula II is from 500 to 15000, or such as from 3000 to 12000 Daltons.

An example of a suitable silyl-modified polyether has the formula III:

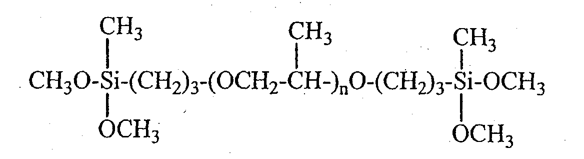

Suitable silyl-terminated polyethers are commercially available from Kaneka Corporation under the names KANEKA MS POLYMER™ and KANEKA SILYL™, and from Union Carbide Specialty Chemicals Division under the name SILMOD™.

The silyl-terminated polymers used in this invention may be straight-chained or branched, and typically have a weight average molecular weight of from 500 to 50,000 Daltons, or such as from 1,000 to 30,000 Daltons.

Any suitable polymer capable of forming anhydride and acid functionalities may be employed in the adhesive compositions. Such polymers may have molecular weights of from 500 molecular weight units to 1 million molecular weight units, or such as from 1000 molecular weight units to 500,000 molecular weight units, or such as from 10,000 molecular weight units to 250,000 molecular weight units. An example of such a resin is an unsaturated polymer, which includes at least one monomer, which is a conjugated diene containing 4 to 12 carbon atoms. The polymer may additionally include a monomer, which is a vinyl substituted aromatic compound including 8 to 20 carbon atoms. Polybutadienes are examples of such polymers. Generally, such polybutadienes are random polybutadiene polymers containing both 1,4 and 1,2-butadiene units. The ratio of 1,2 vinyl and 1,4 cis and trans double bonds in the polymer may be from 15% to 90% 1,2 vinyl or 20% to 70% 1,2 vinyl. Such polymers are commercially available such as from Sartomer® (Grand Junction, Colorado).

Butadiene polymers and copolymers prepared by polymerizing butadiene alone or with other monomers in the presence of alkali metal or organic alkali metal as a catalyst are typical. In order to regulate the molecular weight, to reduce gel content and to form a light-colored polymer, the polymerization is typically a living polymerization which is carried out in a tetrahydrofuran medium or a chain transfer polymerization in which ether such as dioxane and alcohols such as isopropyl alcohol are added and aromatic hydrocarbons such as toluene and xylene are used as the chain transfer agents and the solvent. A polymer in which most of the double bonds in the butadiene units are 1,2 double bonds and which can be used in the present invention may be prepared by polymerizing butadiene alone or with other monomers in the presence of a catalyst comprising a compound of a metal of group VIII of the periodic table and alkyl aluminum. Other polymerization techniques are known to yield polymers having acceptable properties, for example, the free radical polymerization of butadiene using lauryl peroxide as the catalyst.

Examples of copolymers of butadiene with conjugated diolefins other than butadiene include isoprene, 2,3-dimethylbutadiene and piperylene or with vinyl substituted aromatic compounds such as styrene, α-methyl styrene, vinyltoluene and divinylbenzene as co-monomers.

Modified products of butadiene polymers and copolymers which are prepared by heating and partially oxidizing the butadiene polymers and copolymers by passing air through the heated polymer or heated polymer dissolved in appropriate solvents such as xylene or kerosene in the presence of carboxylic acid metallic salts such as cobalt naphthenate or manganese octanoate. They can also be prepared by thermal treatment of the butadiene polymer or copolymer in the presence of organic peroxide.

Suitable polymers may have additional groups such as styrene moieties, which contribute to the physical properties of the polymer but do not interfere with the polymer's ability to form organic anhydride adducts or with the ability of the final product to form strong adhesive bonds with a substrate. Examples of such non-interfering groups include methyl, ethyl, benzyl, tolyl, cyclohexyl, oxygen, halides, and cyano. The adducted unsaturated polymers may include up to 50wt% of such substitutents without interfering with the ability of the polymers to effect adhesion.

The organic acid or derivative moieties of the polymers may be of any type as long as they are adductable to the polymers or polymeric units described above. Maleic anhydrides are one example of, however, other organic acids, anhydrides and derivatives capable of being adducted to the polymer backbones are known in the art or may be ascertained without undue experimentation.

Materials suitable for the formation of organic anhydrides are α,β-ethylenically unsaturated dicarboxylic acid compounds represented by formula IV: 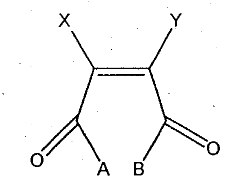 where X and Y are independently hydrogen atoms or alkyl groups, and A and B are hydroxyl groups, alkoxy groups, or salts thereof, or an ―O― bond formed by linking A and B together through a bonded oxygen. The α,β-ethylenically unsaturated dicarboxylic acid compounds include anhydrides of maleic acid such as maleic anhydride and esters of maleic acid such as monomethyl maleic acid, dimethyl maleic acid and diethyl maleic acid and those having 12 or less carbon atoms in each molecule.

Adduction of maleic anhydride, and materials similar to maleic anhydride to unsaturated polymers may be done by any suitable method known in the art. Where the adductable resin contains conjugated unsaturation, a product of the adduction is a Diels-Alder product, which results from a concerted ring closure mechanism. The Diels-Alder reaction results in products with double bonds conjugated with a carbonyl double bond. In an unsaturated polymer chain with a molecular weight of 10,000, which has been adducted with 20wt% maleic anhydride, a single chain may have as many as 20 pendant succinoyl anhydride groups attached to the chain. The acid anhydrides or other acid derivative moieties include from 1wt% to 40wt%, or such as from 10wt% to 35wt%, or such as from 20wt% to 30wt% of the polymer.

In one embodiment a reaction of a polybutadiene random copolymer and maleic acid anhydride provides products having a general formula V: 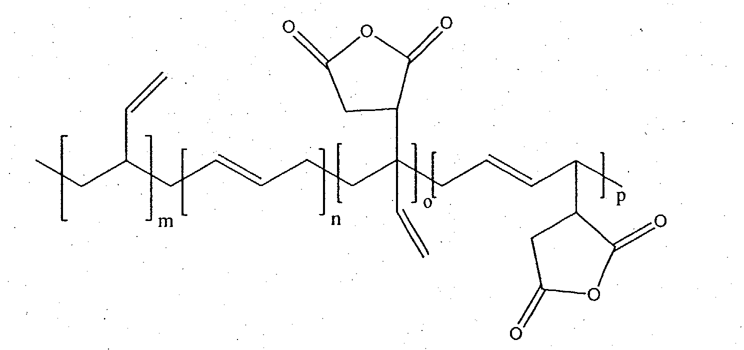 where a ratio of m and n to o and p may be any ratio providing a sufficient amount of acid or derivative moiety to affect the adhesive properties of the cured composition to the desired degree and may be from 1:1 to 30:1 or such as from 3:1 to 20:1.

The silyl-terminated polymers and the adducted polymers are compounded into a mixture or blended together by any suitable method known in the industry. Such methods include roll mill and intensive internal mixers of the Banbury type. The silyl-terminated polymers are mixed with the adducted polymers such that the total polymer component of the adhesive composition include from 2wt% to 98wt% of the silyl-terminated polymers and from 2wt% to 98wt% of the adducted polymers, or such as form 20wt% to 80wt% of the silyl-terminated polymers and from 20wt% to 80wt% of the adducted polymers, or such as from 30wt% to 70wt% of the silyl-terminated polymers and from 30wt% to 70wt% of the adducted polymers.

Any suitable catalyst may be employed to cure the adhesive compositions. Suitable catalysts include, but are not limited to, organometallic catalysts. While not being bound by theory, the curing catalysts enable the silyl-terminated polymers to react with moisture to form a thermoset resin. Catalysts are employed in amounts of from 0.1 wt% to 2wt%, or such as from 0.5wt% to 1wt% of the adhesive compositions. Examples of such suitable catalysts include catalysts such as metal catalysts and alkaline earth catalysts. Examples of such catalysts include titanium catalysts such as diisopropoxybis(2,4-pentanedionato)-titanium, tin catalysts such as dibutylin dilaurate, tin(II) octoate, dibutyl tin naphthanate, dibutyl tin diacetate, and dibutylin dimethoxide. Many of these catalysts are commercially available.

Other suitable catalysts include, but are not limited to, palladium, platinum, rubidium and ruthenium catalysts. Examples of platinum catalysts include platinum black, platinum-on-active carbon, platinum-on-silica micropowder, chloroplatinic acid, platinum-olefin complexes, and platinum-vinylsiloxane complexes. Other platinum catalysts are known in the art. Examples of ruthenium catalysts are arene-ruthenium catalysts. Examples of rhodium catalysts are cyclopentadienyl-rhodium complexes. Other rhodium and ruthenium catalysts are known in the art. Suitable palladium catalysts also are known in the art. Many of these catalysts are commercially available.

Oraganoaluminum compounds also may be used. Examples of such catalysts include aluminum trisacetylacetonate, aluminum tris(ethylacetoacetate) and diisopropoylaluminum ethyl acetoacetate. Such catalysts may are commercially available.

The catalysts may be mixed with the polymers by any suitable method known in the art. The catalysts may be mixed when the polymer mixture is prepared or after the polymers have been mixed as described above.

Generally, the polymers compose from 5wt% to 90wt%, or such as from 20wt% to 80wt%, or such as from 30wt% to 70wt% of the entire adhesive composition. Optional additives as described below may be included in conventional amounts to bring the total weight of the adhesive compositions to 100wt%.

Optional additives include, but are not limited to, rheology modifiers such as plasticizers, extender oils, softeners, thickeners, diluents such as solvents, surfactants, moisture scavengers such as α,β-ethylenically unsaturated compounds, microwave absorbing materials, thermally conductive fillers, inert or reinforcement fillers such as silicas and pigmentation fillers, curing agents, cross-linking agents, flame retardants, blowing agents, and conductive fillers. Such optional components are employed to impart desired properties on the adhesive compositions.

Examples of suitable solvents include water, organic solvents or combinations thereof. Organic solvents include, but are not limited to, alcohols, and ketones. Suitable alcohols include methyl, ethyl, propyl and isopropyl alcohol. Suitable ketones include methyl ethyl ketone (MEK) and acetone.

Examples of suitable rheology agents include various waxes. Such waxes include, but are not limited to, paraffin wax such as straight-chain hydrocarbons with 26-30 carbon atoms/molecule; microcrystalline wax such. as branched-chain hydrocarbons with 41 to 50 carbon atoms/molecule; oxidized microcrystalline waxes such as hydrocarbons, esters, and fatty acids; montan waxes such as wax acids, alcohols, esters, and ketones; ceresin wax; Hoechst waxes such as acids, and esters (obtained by oxidizing montan wax); ozocerite waxes such as saturated and unsaturated high molecular weight hydrocarbons, i.e. greater than 5000 daltons; camauba waxes such as complex alcohols, hydrocarbons, and resins, Japan wax, and bayberry wax; esparto waxes such as hydrocarbons; sugarcane waxes such as hydrocarbons, long straight-chain aldehydes and alcohols; candellia waxes such as hydrocarbons, acids, esters, alcohols, stearols and resins; animal waxes such as beeswax, which includes hydrocarbons, acids, esters, alcohols and lactones, shellac wax and spermaceti wax; synthetic waxes such as Fischer-Tropsch waxes, which include saturated and unsaturated hydrocarbons, and oxygen compounds. Other suitable waxes include polyethylene, polypropylene, fatty acid amide and polytetrafluoroethylene waxes. The waxes may be employed in conventional amounts and may be used individually of may be mixed together to obtain a desired rheology.

Suitable surfactants include ionic, both anionic and cationic, non-ionic and amphoteric surfactants. Surfactants may be employed in conventional amounts.

Any suitable moisture scavenger may be employed. Such moisture scavengers are employed to adsorb moisture from the environment. Moisture scavengers typically are α,β-ethylenically unsaturated compounds such as α,β-ethylenically unsaturated lower alkoxy silanes. Examples of such silanes include vinyl trimethoxy silane, vinyl triethoxy silane and vinyl tripropoxy silane. Other suitable moisture scavengers include, but are not limited to, calcium oxide, magnesium oxide, zinc oxide, talc, zeolites, silica and magnesium sulfate. Such moisture scavengers may be employed in amounts of from 0.1wt% to 5wt%, or such as from 0.5wt% to 4wt%, or such as from 1wt% to 3wt% of the adhesive composition.

When the adhesive compositions are employed as gaskets for EMI or RFI shielding, or as antistatic coatings on articles such as tool handles, conductive fillers are included. Any suitable conductive filler, which may be used to shield undesired radiation may be employed. Examples of such fillers include, but are not limited to, electrically conductive noble metal-based fillers such as pure silver; noble metal-plated noble metals such as silver plated gold; noble metal-plated non-noble metals such as silver plated copper, nickel, or aluminum, for example, silver plated aluminum core particles, silver plated copper core particles, or platinum plated copper particles; noble-metal plated glass, plastic or ceramics such as silver plated glass microspheres, noble-metal plated alumina, or noble-metal plated plastic microspheres; noble-metal plated mica; and other such noble-metal conductive fillers. Non-noble metal based materials also are suitable, including non-noble metal-plated non-noble metals such as copper-coated iron particles or nickel plated copper; non-noble metals such as copper, aluminum, nickel, cobalt; and non-metal materials such as carbon black, and graphite and combinations of the fillers to meet the desired electrical conductivity desired for a particular application. Non-metal materials such as inherently conducting polymers and conducting polymer composites, such as polyaniline and polythiophene may be used. Such conductive fillers are commercially available or may be made according to methods disclosed in the literature.

The conductive filler particles may be of any shape that is generally used in the manufacture of such fillers including spherical, flake, platelet, irregular, or fibrous (such as chopped fibers). The average size of such particles ranges from 0.1 micron to 500 microns, or such as from 15 microns to 200 microns, or such as from 20 microns to 150 microns or such as 35 microns to 80 microns.

Conductive fillers are included in amounts sufficient to achieve the desired electrical conductivity and provide the desired EMI and RFI shielding. Generally, conductive fillers are included in the adhesive compositions in amounts of 35wt% to 85wt% or such as from 60wt% to 75wt% of the compositions. The remainder of the adhesive compositions is composed of the polymer mixture, catalysts and any other optional components described above.

When conductive fillers are included in the adhesive compositions, the polymer mixture composes from 5wt% to 40wt%, or such as from 10wt% to 30wt%, or such as from 15wt% to 25wt% of the adhesive compositions. The remainder of the compositions includes one or more catalysts and one or more of the optional additives to bring the composition to 100wt%.

When conductive fillers are not employed to provide conductivity to a gasket, a conductive outer layer may be used to provide the conductivity to the gasket. The conductive outer layer may be in the form of a coating or a film. Films such as a conductive polyethylene, polyimide, silicon, polyurethane, acrylic and epoxy resins filled with one or more of the conductive fillers described above may be used. Inherently conducting polymers and conducting polymer composites, such as polyaniline, polythiophene may also be used.

The EMI shielding effectiveness of the conductive adhesive compositions is from at least 40 dB, or such as 40 dB to 80 dB, or such as from 50 dB to 75 dB over a range of frequencies from 20 MHz to 20 GHz. Shielding effectiveness varies with the amount of conductive material present, the deflection imposed upon the gasket and the test method used. The values above assume a typical loading of conductive materials with at least 10% deflection and standard MIL specification test procedures.

The process of applying the adhesive compositions includes the use of automated equipment such as robotic applicators, such as x-y, x-y-z and other multiaxis or rotational type or applicators; hand applicators such as caulking guns, transfer applicators and other processes known in the art. The adhesive compositions may be applied by automated equipment in diameters ranging from 0.02 cm and wider, or such as from 0.5 cm to 5 cm.

The processes relate to the formation of an adhesive composition which is capable of being formed in place, applying the composition to a substrate along a predetermined pathway and curing the composition in place. The adhesive composition forms a hermetic seal.

An example of one method is to use a stationary support or table to which the substrate to be gasketed is fixed in place. A movable applicator, such as a programmable x-y or x-y-z nozzle, which is connected to a supply of form-in-place adhesive, is positioned adjacent and above the substrate and then caused to travel along a predetermined path, applying the adhesive to the portion of the substrate over which it travels in a desired amount. The adhesive composition is then cured.

Alternatively, the nozzle may be stationary and the table may be caused to move in two (x-y), three (x-y-z) or more planes of movement.

In a further embodiment both the nozzle and the table may move in one or more planes relative to each other. One example is where the nozzle moves in two planes (x-y) and is rotational as well and the table is capable of vertical (z) movement.

Another method is to form a non-conductive adhesive composition and then form a conductive outer layer over the non-conductive adhesive via spraying, coating, painting or dipping the conductive outer layer onto the adhesive.

When the adhesive compositions are used as antistatic coatings on articles such as tools, floors, table-tops, door knobs and plastic coatings the adhesive compositions are applied by dip coating, spray coating or other suitable method. Such antistatic coatings typically are applied on articles in a thickness range of from 0.01 mm to 10 mm, or such as from 0.5 mm to 5 mm.

The adhesive compositions may be cured by any suitable mechanism, which does not adversely affect the slump properties of the gasket between application and cure, and the physical and electrical properties of the cured composition. Typically the adhesive compositions are moisture cured. The adhesive compositions cure in the presence of a catalyst and moisture. Because the adhesive compositions cure in the presence of moisture, they are typically stored in an inert gas atmosphere such as an argon atmosphere. Moisture scavengers as described above may be added to the adhesive compositions in the amounts specified. Moisture cure typically begins within 5 minutes and is completed within 30 minutes to 24 hours after application.

The adhesive compositions may be used to form adhesive bonds between various articles, and employed as electrically conductive shielding gaskets and antistatic coatings in numerous electronic devices. Such devices include hand held devices such as cellular phones and notebook computers as well as automotive and aerospace electronics.

### Example 1

### Adhesion Test on Copper Plates

An adhesive composition of a two-polymer component system is made. The first polymer is a trimethoxy silyl ether polymer having an average molecular weight of 5000 Daltons weight units and the second polymer is a random polybutadiene containing both 1,4 and 1,2 butadiene units. The polybutadiene polymer has pendent anhydride functionalities, which compose 20wt% of the polybutadiene polymer. The anhydride functionalities are derived from maleic anhydride. The average molecular weight of the polybutadiene polymer is 250,000 Daltons.

The trimethoxy silyl ether polymer is blended with the polybutadiene polymer in a weight ratio of 98:2. The polymers are blended together in a Bandbury type of mixer at 20° C until a uniform mixture is obtained.

Diisopropoxybis(2,4-pentanedionato)-titanium catalyst is added in a sufficient amount to the polymer mixture such that it composes 0.1wt% of the mixture. Vinyl trimethoxy silane and polyethylene wax are then added to the mixture to make up 0.5wt% and 2wt% of the mixture, respectively. Methyl alcohol is then added to the mixture such that it composes 10wt% of the composition.

The mixed composition is added to a 10 ml hand held syringe. The material is forced out of the syringe as beads having an average diameter of 560 microns onto each of 15 copper plates (10 cm long, 5 cm wide, and 0.5 cm thickness). Each plate has an average of 3 beads. The composition moisture cures over 30 minutes at 20° C. The average aspect ratio (bead height/width) of the beads after cure is 0.9. The bead is measured using a conventional apparatus.

The adhesion of each bead is tested by sectioning the beads into 10 mm long segments. The adhesive force ranges from 1.5 N/cm to 2.5 N/cm with an average of 2 N/cm. The adhesive force is the amount of force for dislodging the 10 mm long beads from the copper plates.

### Example 2

### Adhesion to Aluminum Plates

An adhesive composed of a dimethoxy silyl ether polymer having an average molecular weight of 20,000 Daltons and a second polymer which is a random polybutadiene containing both 1,4 and 1,2 butadiene units. The average molecular weight of the random polybutadiene is 200,000 Daltons. The polybutadiene polymer has pendent anhydride and acid functionalities, which compose 30wt% of the polybutadiene polymer. The anhydride and acid functionalities are derived from maleic anhydride and esters of maleic acid such as monomethyl maleic acid, dimethyl maleic acid and diethyl maleic acid.

The dimethoxy silyl ether polymer is blended with the polybutadiene polymer in a weight ratio of 90:10. The polymers are blended together in a Bandbury type mixer at 22° C until a uniform mixture is obtained.

Dibutyl tin dilaurate catalyst is added in a sufficient amount to the polymer mixture such that it composes 0.5wt% of the mixture. Vinyl trimethoxy silane and a polyamide wax are then added to the mixture to make up 1wt% and 3wt% of the mixture, respectively. MEK is then added to the mixture such that it composes 10wt% of the composition.

The composition is added to a 10 ml hand held syringe. The material is forced out of the syringe as beads having an average diameter of 550 microns onto each of 20 aluminum plates (15 cm long, 10 cm wide, and 0.5 cm thickness). Each plate has an average of 3 beads. The composition moisture cures over 60 minutes at 22° C. The average aspect ration of the beads after cure is 0.8.

The adhesion of each bead is tested by sectioning the beads into 10 mm long segments. The adhesive force ranges from 1 N/cm to 2.5 N/cm with an average of 1.7 N/cm. The adhesive force is the amount of force for dislodging the 10 mm wide beads from the aluminum plates.

### Example 3

### Adhesion to Electroless Nickel

An adhesive composition is prepared by mixing a triethoxy silyl ether polymer having an average molecular weight of 15,000 Daltons and a second polymer, which is a styrene-butadiene-styrene copolymer with pendent anhydride and acid functionalities. The average molecular weight of the copolymer is 150,000 Daltons. The anhydride and acid functionalities compose 27wt% of the copolymer.

The triethoxy silyl ether polymer is blended with the styrene-butadiene-styrene copolymer in a weight ratio of 80:20. The polymers are blended together in an intensive internal mixer at 24° C until a uniform mixture is obtained.

Tin(II) octoate catalyst is added in a sufficient amount to the polymer mixture such that it composes 1 wt% of the mixture. Vinyl trimethoxy silane and a polypropylene wax are then added to the mixture to make up 0.25wt% and 5wt% of the mixture, respectively. MEK is then added to the mixture such that it composes 15wt% of the composition.

The composition is added to a 10 ml hand held syringe. The composition is forced out of the syringe as beads having an average diameter of 560 microns onto each of 10 electrolessly nickel plated G-10 epoxy laminates measuring 5 cm by 15 cm. Each laminate has an average of 4 beads. The composition moisture cures over 30 minutes at 20° C. The average aspect ratio of the beads after cure is 0.9.

The adhesion of each bead is tested by sectioning the beads into 10 mm long segments. The adhesive force ranges from 2 N/cm to 3 N/cm with an average of 2.5 N/cm.

### Example 4

### Adhesion Test on Conductive Paints

A tripropoxy silyl ether polymer having an average molecular weight of 20,000 Daltons is mixed with a random polybutadiene polymer in a weight ratio of 95:5. The random polybutadiene polymer contains both 1,4 and 1,2 butadienes units and has an average molecular weight of 100,000 Daltons. The polybutadiene has pendent anhydride and acid functionalities, which compose 30wt% of the polymer. The polymers are mixed together in a Bandbury type mixer at 23° C until a uniform mixture is obtained.

Tin(II) octoate catalyst is added in a sufficient amount to the polymer mixture such that it composes 1wt% of the mixture. Vinyl triethoxy silane and polyethylene are then added to the mixture such they compose 1wt% and 5wt% of the mixture, respectively. A sufficient amount of acetone is added to the mixture such that it composes 10wt% of the composition.

The adhesive composition is added to a 10 ml hand held syringe. The material is forced out of the syringe as beads with an average diameter of 550 microns onto each of 10 polystyrene plates (10 cm long, 5 cm wide and 1 cm thick). The polystyrene plates are coated with a conductive alkyd paint. Each plate has an average of 4 beads. The composition moisture cures over 60 minutes at 21° C. The average aspect ration of the beads after cure is 0.85.

The adhesion of each bead is tested by sectioning the beads into 10 mm long segments. The adhesive force ranges from 1.7 N/cm to 2.5 N/cm with an average of 2.1 N/cm.

### Example 5

### Adhesive Test for Conductive Composition

A dimethoxy silyl ether polymer with an average molecular weight of 10,000 Daltons is mixed with a random polybutadiene polymer with an average molecular weight of 15,000 Daltons. The random polybutadiene polymer contains 1,2 and 1,4 butadiene units, and pendent anhydride functionalities. The anhydride functionalities compose 30wt% of the polybutadiene polymer. The dimethoxy silyl ether polymer is blended with the random polybutadiene polymer in a weight ratio of 85:15. Mixing is done in a Brandbury type mixer at 22° C until a uniform mixture is obtained.

Dibutyl tin dilaurate catalyst is added in a sufficient amount such that it composes 1wt% of the composition. Vinyl trimethoxy silane and a polyamide wax are blended with the mixture in amounts sufficient to compose 0.5wt% and 1wt% of the composition, respectively.

Silver coated copper particles with an average size of 35 microns are added to the mixture in an amount such that they compose 70wt% of the composition. MEK is then added to the mixture in a sufficient amount to compose 5wt% of the composition.

The mixed composition is added to a 10 ml hand held syringe. The composition is forced out of the syringe as beads having an average diameter of 560 microns onto each of 10 electrolessly nickel plated epoxy plates (10 cm long, 5 cm wide and 1 cm thick) and 10 conductive paint coated polystyrene plates (10 cm long, 5 cm wide and 1 cm thick). Each plate has an average of 4 beads. The composition moisture cures over 30 minutes at 23° C. The average aspect ratio of the beads after cure is 0.9.

The adhesion of each bead was determined by sectioning the beads into 10 mm long segments on each of the plates. Adhesion of the beads on the electroless nickel plates is from 1.8 to 2.2 N/cm, and the adhesion on the conductive paint plates also is 1.8 to 2.2 N/cm. The results show that the adhesion composition has a high adhesion to substrates.

### Example 6

### Shielding Effectiveness of Adhesive Composition

A conductive adhesive as in Example 5 is prepared. The conductive adhesive is deposited on 10 epoxy laminates (10 cm wide, 20 cm long and 5 cm thick) coated with electroless nickel to a thickness of 1 mm, and 10 polystyrene plates (10 cm wide, 20 cm long and 5 cm thick) with a 1mm coat of conductive paint. The conductive adhesive moisture cures over 30 minutes at 20° C to form a film on each laminate and plate of an average thickness of 2 mm.

The conductivity of each layer on the laminates and plates ranges from 0.6 to 0.7 ohms over an 8 cm path as measured with a two probe system. Shielding effectiveness of each of the laminates and plates with the coats of conductive adhesives is determined using ASTM D-4935-84 procedure at a range of frequencies of 30 MHz to 1.5 GHz. The reference is a copper foil with a shielding effectiveness of 58 to 70 dB over a range of frequencies of 30 MHz to 1.5 GHz. The copper foil has a thickness of 2 mm. The results show that the shielding effectiveness of the conductive adhesive coatings ranges from 52 to 74 dB. The conductive adhesive coatings have an increased effective shielding range than does a standard copper foil. Accordingly, the conductive adhesives are an improvement over standard copper foils, which are used as gaskets to shield undesirable EMI and RFI for electronic devices.

## Claims

1. A composition comprising at least one silyl-terminated polymer, at least one polymer comprising anhydride or acid functionalities or combinations thereof, and one or more catalysts.

2. The composition of claim 1, wherein the silyl-terminated polymer is chosen from one or more of a silylated polyurethane, silylated polyether and a silyated polyester.

3. The composition of claim 1, wherein the polymer comprising the anhydride or the acid functionalities, or the combinations thereof is a polymer or copolymer of butadiene.

4. The composition of claim 3, wherein the anhydride functionalities are derived from compounds of the formula IV: 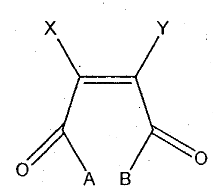 where X and Y are hydrogen atoms or alkyl groups and may be the same or different; and A and B are hydroxyl groups, alkoxy groups, or salts thereof, or an ―O― bond formed by linking A and B together.

5. The composition of claim 4, wherein the compounds are chosen from anhydrides of maleic acid and esters of maleic acid.

6. The composition of claim 1, wherein a weight ratio of the silyl-terminated polymer to the polymer comprising the anhydride functionalities, acid functionalities or combinations thereof ranges from 98:2 to 2:98.

7. The composition of claim 1, further comprising one or more moisture scavengers.

8. The composition of claim 1, further comprising one or more conductive fillers.

9. A form-in-place gasket comprising a composition formed from at least one silyl-terminated polymer, at least one polymer comprising anhydride functionalities, acid functionalities or combinations thereof, one or more catalysts, one or more conductive fillers, and one or more moisture scavengers.

10. An article comprising a first electrically conductive substrate; a second electrically conductive substrate adjacent to the first substrate; and a form-in-place gasket formed on and bonded to a predetermined portion of the first substrate to provide electrical connection and EMI shielding between the first and second substrate, the form-in-place gasket comprises a composition formed of at least one silyl-terminated polymer, at least one polymer with anhydride or acid functionalities or combinations thereof, and one or more electrically conductive fillers.
